# EUROPEAN PATENT SPECIFICATION

(11) **EP 0 575 100 B1**
(45) Date of publication and mention of the grant of the patent: **29.04.1998**
(21) Application number: 93304514.8
(22) Date of filing: 10.06.1993
(51) Int. Cl.: G01R 31/02, H04L 12/26, H04Q 1/14, H04M 3/28

(54) **Patching panel scanner**
Abtaster für Steckfeld
Balayeur de panneau de commutation

(30) Priority: 10.06.1992 US 896420; 07.09.1992 IL 103092
(43) Date of publication of application: 22.12.1993
(73) Proprietor: RIT TECHNOLOGIES LTD., Tel Aviv 69710 (IL)
(72) Inventor: Krupka, Yaakov, Rehovot 76280 (IL); Zisapel, Yehuda, Tel Aviv 69355 (IL)
(74) Representative: Hillier, Peter

(56) References cited:
- AT-A- 357 634
- FR-A- 2 680 067
- GB-A- 2 236 398

## Description

The present invention relates to computer communication generally and more particularly to apparatus for interconnection of data ports.

Computer communications have become commonplace in recent years. In modern work environments, local area networks are provided for interconnecting a plurality of computers and peripheral apparatus. Generally, the local area networks incorporate computer cabling systems which include distribution panels at which connection between various computer ports and user ports are located.

In many cases, the interconnections between the various ports are relatively complicated and often create a cabling spaghetti, which is extremely difficult to manage. As a result computer software has been developed to enable management of cabling systems. A review of such software appears in "The Great Cabling Treasure Hunt" by M. Jander, Data Communications, March 21, 1991.

Even using the most advanced cable management software, there nevertheless remains a massive job of manually entering connection information for use by the software.

A self documenting patch panel is disclosed in GB-A-2236398 and a method for documenting the connections between input and output ports of a patch panel. Each port has a polling terminal associated with it; a polling signal is sent to each of the input polling terminals of the input ports in turn, and the outputs whose polling terminals receive the signal are identified as being connected to that port. The sending circuitry includes serial parallel shift registers and the receiving circuitry includes parallel to serial shift registers.

A device for identifying electrical conductors, e.g. cables, is disclosed in AT-A-357 634, wherein a highfrequency signal is applied to the conductors at one point by capacitive or inductive coupling and is picked up at another point also by capacitive or inductive coupling. A high frequency carrier wave is modulated with a low frequency coded wave which can be detected by the apparatus for identification.

The present invention seeks to provide apparatus for obviating the present manual task of identifying and collecting cable connection information.

The invention provides apparatus for providing an indication of the connection pattern of a multiplicity of data ports, pluralities of which are interconnected by conductors, said apparatus comprising signal transducer means operatively associated with at least some of said conductors at the ends thereof adjacent said data ports, at least one of said signal transducer means associated with at least one of said conductors being operative to impose a signal on a portion of said conductor and at least one of said signal transducer means associated with at least one of said conductors being operative to pick off said signal from said conductor; a scanner connected to said transducer means for automatically scanning the interconnection arrangement of said conductors and thus determining the interconnection status of said data ports, characterised in that the apparatus also includes a plurality of visual indicators each associated with one of said multiplicity of data ports, pairs of said visual indicators being simultaneously illuminated for providing an output indication of the interconnection status of pairs of data ports.

In accordance with a preferred embodiment of the invention, the apparatus also comprises means for distinguishing signals passing along predetermined signal paths from signals passing along other signal paths, according to their phase.

Additionally or alternatively, the apparatus includes means for distinguishing signals passing along predetermined signal paths from signals passing along other signal paths, according to their delay time constant.

Additionally or alternatively, the apparatus includes means for distinguishing signals passing along predetermined signal paths from signals passing along other signal paths, according to their amplitude.

In a preferred embodiment of the present invention, at least some of the conductors are arranged in a plurality of cables, each cable including at least one conductor.

Further, in accordance with a preferred embodiment of the present invention, the plurality of cables includes shielded cables and the signal transducer means includes induction means operatively associated with shielding of the shielded cables at the ends thereof adjacent the data ports, at least one of the induction means associated with each shielded cable being operative to impose a signal on the shielding of the cable and at least one of the induction means associated with each shielded cable being operative to pick off the signal from the shielding of the cable.

In a preferred embodiment of the invention, the signal transducer means is operative to impose a signal on at least one conductor which does not carry any other signal.

Additionally or alternatively, the signal transducer means is operative to impose a signal on at least one conductor which may carry other signals and includes means for isolating the signal imposed thereby from the other signals, thereby to prevent unacceptable interference therewith. According to a preferred aspect of this embodiment of the invention the means for isolating includes means for differentiating signals by phase.

Additionally or alternatively, the means for isolating includes means for differentiating signals by delay time constant.

Additionally or alternatively, the means for isolating includes means for differentiating signals by amplitude.

In a preferred embodiment of the invention, the indication of the connection pattern of the data ports is provided automatically.

In a preferred embodiment of the invention, the visual indicators are LEDs electrically associated with the induction means.

In a preferred embodiment of the invention, the apparatus also includes manually controllable means for scanning the ports to provide indication of the pairs of interconnected ports by a light source apparatus.

In accordance with another, preferred, embodiment of the present invention there is provided a local area network including cabling interconnecting a plurality of workstations, the cabling including indication apparatus according to any of the embodiments described above wherein the conductors are used for selectable and removable interconnection between selected ones of the data ports.

In accordance with yet another, preferred, embodiment of the invention there is provided a computer system including at least one main computer, a plurality of workstations and a local area network interconnecting the at least one main computer and the plurality of workstations, the local area network including indication apparatus according to any of the embodiments described above wherein the multiplicity of data ports includes at least one computer port and a plurality of user ports and wherein the conductors are used for selectable and removable interconnection between selected ones of the user ports and the at least one computer port, thereby providing an indication of the connection pattern of the at least one computer port and the user ports.

### BRIEF DESCRIPTION OF THE DRAWINGS

The present invention will be more fully understood and appreciated from the following detailed description, taken in conjunction with the drawings in which:
Figs. 1A, 1B and 1C are simplified illustrations of a computer system constructed and operative in accordance with three alternative preferred embodiments of the invention;
Fig. 2 is a simplified detailed illustration of part of the system of Figs. 1A - 1C;
Fig. 3 is a simplified detailed illustration of part of the apparatus of Fig. 2;
Fig. 4 is a simplified detailed illustration of part of the apparatus of Fig. 3;
Fig. 5 is a side view illustration taken along the lines V - V of Fig. 4;
Figs. 6A, 6B, 6C, 6D and 6E are simplified illustrations of five typical circuit arrangements useful in the apparatus of Figs. 3 - 5;
Fig. 7 is a simplified illustration of an alternative embodiment of part of the apparatus of Figs. 1A - 1C and 2;
Fig. 8 is a simplified illustration of a further alternative embodiment of part of the apparatus of Figs. 1A - 1C and 2;
Fig. 9 is a simplified conceptual illustration of the apparatus of Figs. 3 - 6E, indicating an aspect of its operation;
Figs. 10A and 10B are illustrations of signal paths which occur for two different connection arrangements in the apparatus of Fig. 9;
Figs. 11A and 11B are timing diagrams illustrating differentiation between desired signals and interference along the signal paths of Figs. 10A and 10B;
Fig. 12 is an illustration of signal paths which occur for another two alternative connection arrangements in the apparatus of Fig. 9;
Figs. 13A and 13B are timing diagrams illustrating differentiation between desired signals and interference along the signal paths of Fig. 12;
Fig. 14 is an overall diagram of a specific embodiment of the scanner apparatus of Fig. 2;
Figs. 15A, 15B and 15C are simplified illustrations of a computer system constructed and operative in accordance with three additional alternative preferred embodiments of the invention;
Fig. 16 is a simplified detailed illustration of part of the apparatus of Fig. 3 as modified in accordance with the embodiments of Figs. 15A, 15B or 15C; and
Fig. 17 is a simplified illustration of an alternative embodiment of part of the apparatus of Figs. 15A - 15C.

### DETAILED DESCRIPTION OF A PREFERRED EMBODIMENT

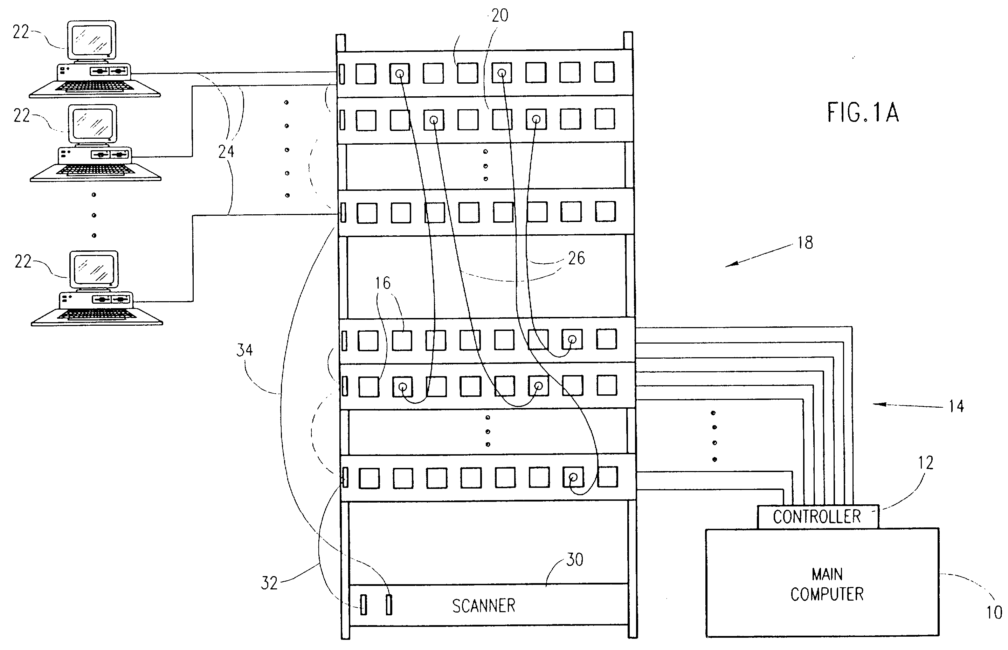

Reference is now made to Fig. 1A, which illustrates a computer system constructed and operative in accordance with a preferred embodiment of the present invention. The computer system comprises a main computer 10, such as an IBM mainframe, which is coupled, typically via a controller 12, such as a IBM 3270, and local area network cabling 14, typically type I, ICS cabling, to a plurality of computer ports 16 forming part of a distribution panel 18.

The distribution panel 18 also comprises a plurality of user ports 20 to which are coupled individual computers, terminals or work stations 22, hereinafter referred to collectively as "work stations", by apparatus of local area network cabling 24, such as type I, ICS cabling.

Interconnections between individual computer ports 16 and individual user ports 20 are provided by patching cables 26 or alternatively by apparatus of internal connections in patching panels such as the CLPP cordless patching panel commercially available from RIT Technologies Ltd. of Tel Aviv, Israel, and as described in Israel Patent Application 97,227.

In accordance with a preferred embodiment of the present invention, a scanner 30 is provided for automatically and, preferably, repeatedly scanning the interconnection arrangement of the patching cables and, thus, determining the interconnection status of the various computer ports 16 and user ports 20. The scanner 30 may provide an interconnection status output to computer 10 or to any other computer or display in the system, including, for example, a dedicated output device.

Scanner 30 is coupled to computer ports 16 via cables 32 and is coupled to user ports 22 by means of cables 34.

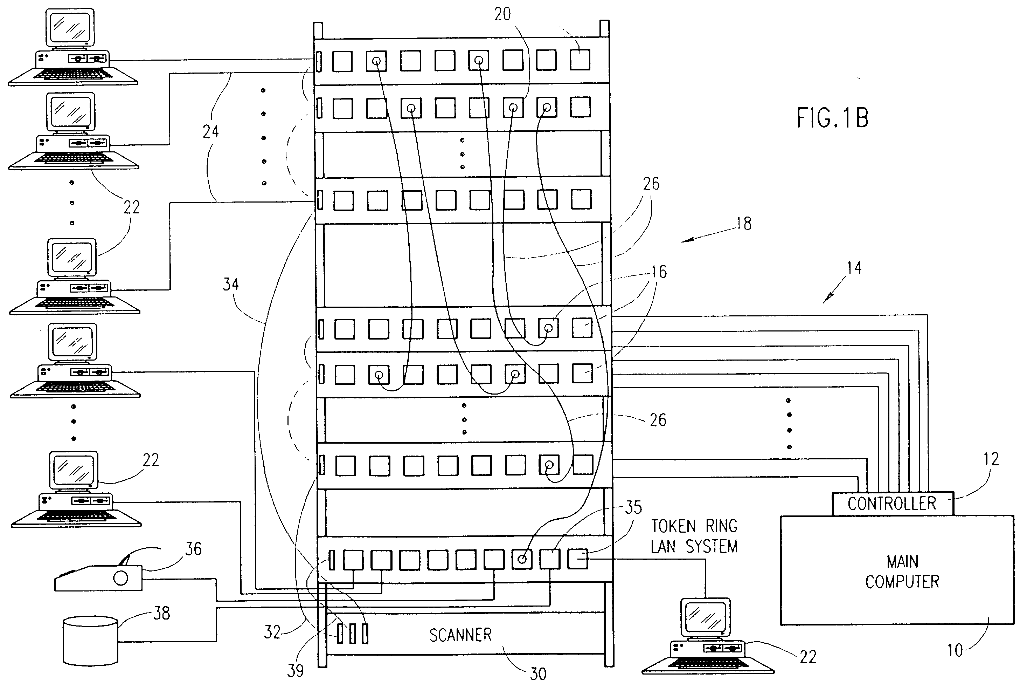

Reference is now made to Fig. 1B, which illustrates a computer system constructed and operative in accordance with another preferred embodiment of the present invention. Similarly to the embodiment of Fig. 1A, the computer system comprises a main computer 10, which is coupled, typically via a controller 12, and local area network cabling 14, to a plurality of computer ports 16 forming part of a distribution panel 18.

As in the embodiment of Fig. 1A, the distribution panel 18 also comprises a plurality of user ports 20 to which are coupled work stations, by means of local area network cabling 24.

As distinguished from the embodiment of Fig. 1A, the distribution panel 18 also includes a plurality of token ring LAN ports 35 which are interconnected by a conventional token ring LAN. Work stations 22 as well as peripheral devices such as printers 36 and disk storage devices 38 may also be coupled to the token ring LAN ports 35.

Interconnections between individual computer ports 16, individual user ports 20 and LAN ports 35 are provided by patching cables 26 or alternatively by means of internal connections in patching panels, as mentioned above.

In accordance with a preferred embodiment of the present invention, scanner 30 is provided for automatically and, preferably, repeatedly scanning the interconnection arrangement of the patching cables and, thus, determining the interconnection status of the various computer ports 16, user ports 20, and LAN ports 35. The scanner 30 may provide an interconnection status output to computer 10 or to any other computer or display in the system, including, for example, a dedicated output device.

Scanner 30 is coupled to computer ports 16 via cables 32, to user ports 22 by means of cables 34 and to LAN ports 35 by means of cables 39.

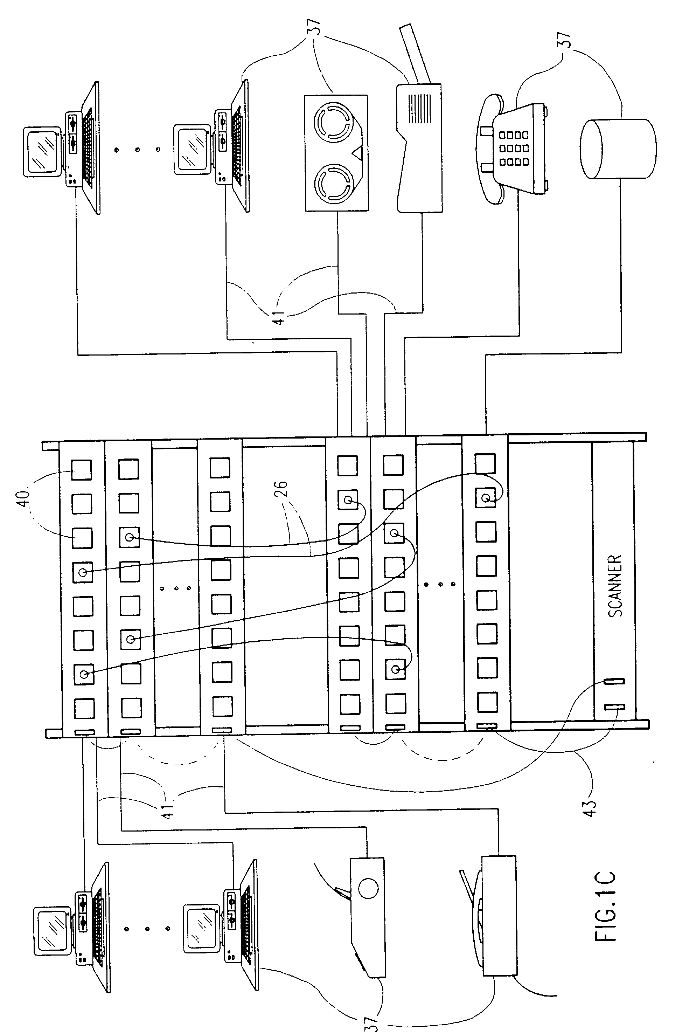

Reference is now made to Fig. 1C, which illustrates a computer system constructed and operative in accordance with yet another preferred embodiment of the present invention. As distinguished from the embodiments of Figs. 1A and 1B, the computer system need not comprise a main computer but rather may comprise workstations and peripherals, collectively denoted by reference numeral 37, as desired. A multiplicity of ports 40, which need not be classified as computer ports, user ports or LAN ports, are preferably connected to the workstations and peripherals, as the case may be, by local area network cabling 41.

Interconnections between individual ports 40 are provided by patching cables 26 or alternatively by means of internal connections in patching panels, as mentioned above.

In accordance with a preferred embodiment of the present invention, scanner 30 is provided for automatically and, preferably, repeatedly, scanning the interconnection arrangement at least of patching cables 26 and possibly of the internal connections and, thus, determining the interconnection status of the various ports 40. The scanner 30 may provide an interconnection status output to any computer, workstation, or peripheral in the system, including, for example, a dedicated output device.

Scanner 30 is coupled to the various ports via cables 43.

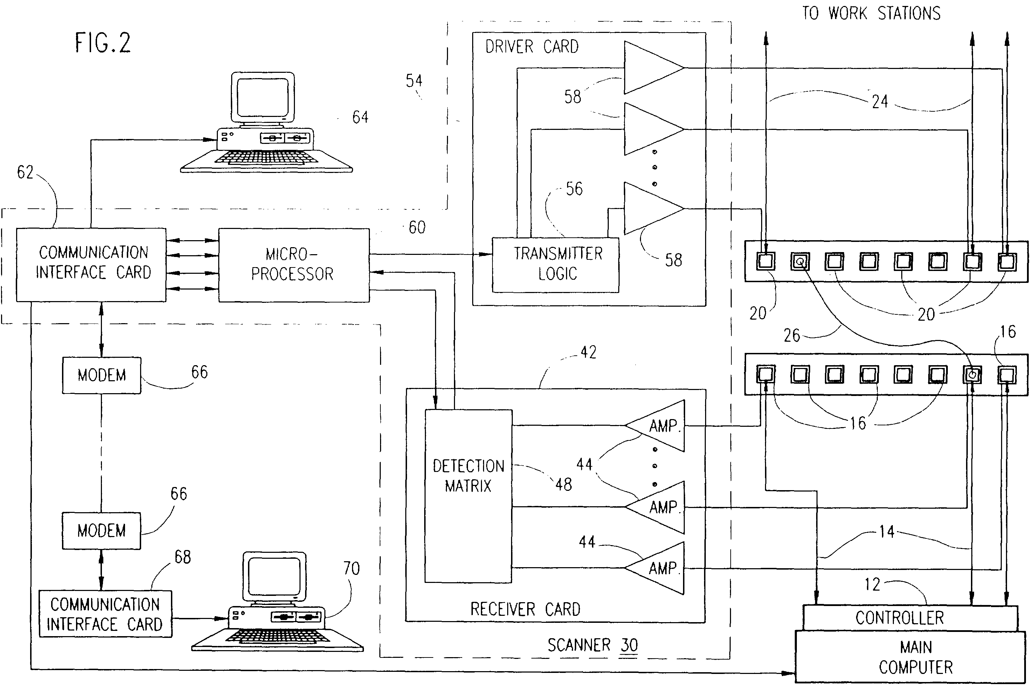

Reference is now made to Fig. 2 which is a more detailed illustration of part of the scanner apparatus of Fig. 1A. It is to be appreciated that the structure illustrated in Fig. 2 and the remaining figures herein is applicable in principle also to the embodiments of Figs. 1A - 1C.

As seen in Fig. 2, the controller 12 is connected via cabling 14 to computer ports 16, which are in turn coupled to scanner 30. Scanner 30 includes a plurality of receiver cards 42, each of which includes a plurality of pre-amplifiers 44, such as OP 16 amplifiers, commercially available from Analog Devices, each inputted from a single port 16 and outputting to a detection matrix 48, whose function is to determine at which user port 20 there are present signals transmitted via a patch cable 26 from a given computer port 16.

A plurality of work stations are connected by means of cabling 24 to corresponding user ports 20 which are coupled, in turn, to driver cards 54 of scanner 30. The driver card 54 includes transmitter logic circuitry 56, a preferred embodiment of which is described hereinafter in greater detail, which outputs to the individual user ports 20 via a plurality of corresponding drivers 58, such as 2N3906 transistors, commercially available from Motorola.

The transmitter logic circuitry 56 receives scanning inputs from a microprocessor 60 which provides overall control functions for the scanner 30 and controls both the detection matrix 48 and the transmitter logic circuitry 56.

Generally speaking, microprocessor 60 causes signal inputs to be applied to the various user ports 20 and scans the computer ports 16 to detect such signal inputs. In such a way, scanner 30 is operative to determine which user ports 20 are connected to which computer ports 16.

Microprocessor 60 is also operative to report information regarding which user ports 20 are connected to which computer ports 16, via a communication interface card 62, either to an adjacent computer 64 or, alternatively, via a pair of modems 66 and another communication interface card 68 to a remotely located computer 70. Alternatively or additionally, the microprocessor 60 may report the connection status via communication interface card 62 to the main computer. The connection to the main computer may be direct or via the LAN system.

It is to be appreciated that the user ports 20 and the computer ports 16 may be interchanged in the system of Fig. 2, such that the driver cards 54 are coupled to the computer ports 16 and the receiver cards 42 are coupled to the user ports 20. It is further noted that, as in the embodiment of Fig. 1C, the distinction between user ports and computer ports may be eliminated entirely, and signals may be transmitted at any selected port and picked off at any selected port. Furthermore, it is envisioned that the interconnection status of ports which are not interconnected by patch cables 26, but rather by other conductors, may also be determined on a real time basis in accordance with the present invention.

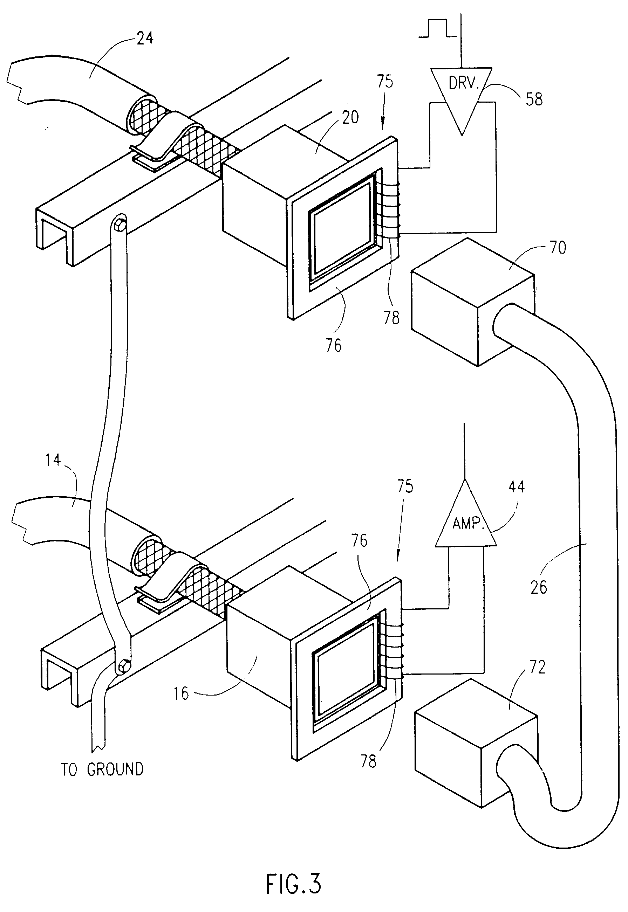

Reference is now made to Fig. 3, which illustrates in greater detail the interconnections between an individual user port 20 and an individual computer port 16. The patch cable 26 is shown with connectors 70 and 72 adapted for connection to the user port 20 and the computer port 16.

In accordance with a preferred embodiment of the present invention, there is associated with each of computer ports 16 and user ports 20 an inductive coupler 75, typically comprising a ferromagnetic frame 76, which is wound with a coil 78. The coil 78 of the coupler 75 associated with user port 20 is coupled to the output of driver 58, while the coil 78 of the coupler 75 associated with computer port 16 is coupled to the input of amplifier 44. When patch cable 26 is connected between user port 20 and computer port 16, signals generated from driver 58 are induced by coil 78 of the coupler 75 associated with port 20 onto connector 70 of patch cable 26. The signals carried by patch cable 26 are then induced, by connector 72 at the other end of the cable, onto coil 78 of the coupler 75 associated with port 16 and, thereby, received by amplifier 44. Thus, when port 20 and port 16 are coupled by patch cable 26, as described above, any signal generated from driver 58 is picked up by amplifier 44.

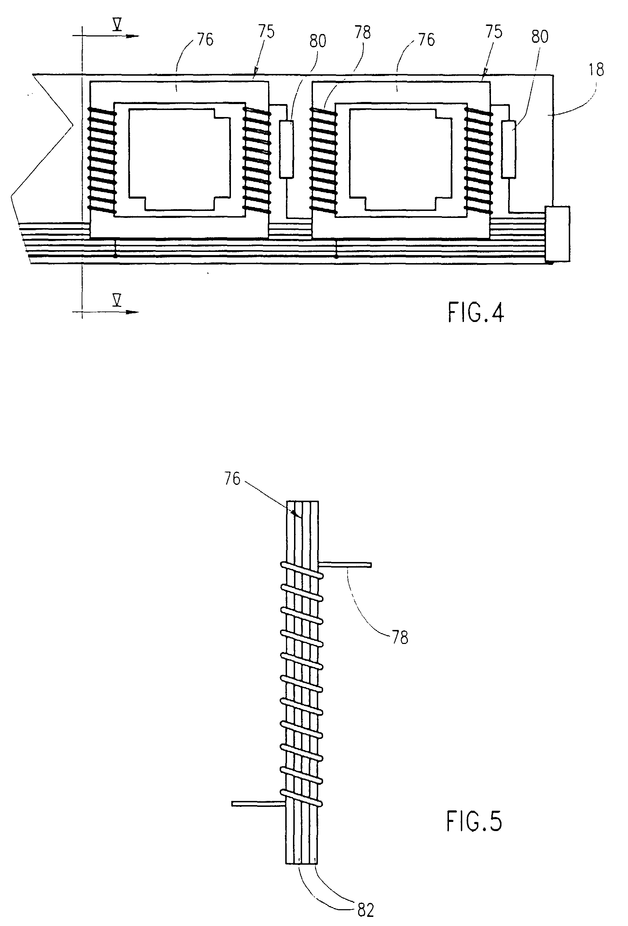

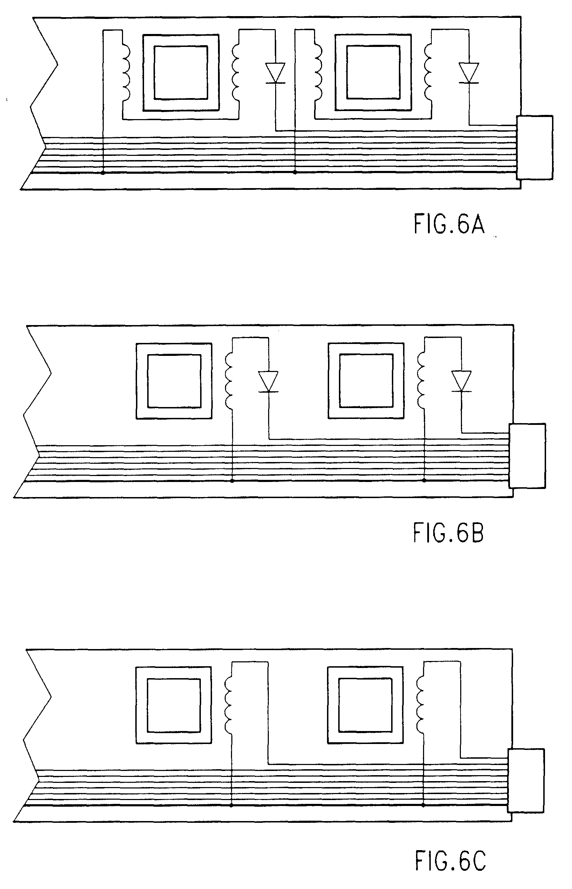

Figs. 4 and 5 illustrate in even greater detail a preferred embodiment of part of a distribution panel 18 including a plurality of ports 16 or 20 together with their inductive couplers 75 and the wiring thereto including matrix diodes 80, such as lN4148 diodes. It is seen that frames 76 typically include a plurality of parallel plates 82 and typically two coils 78 are associated with each frame 76.

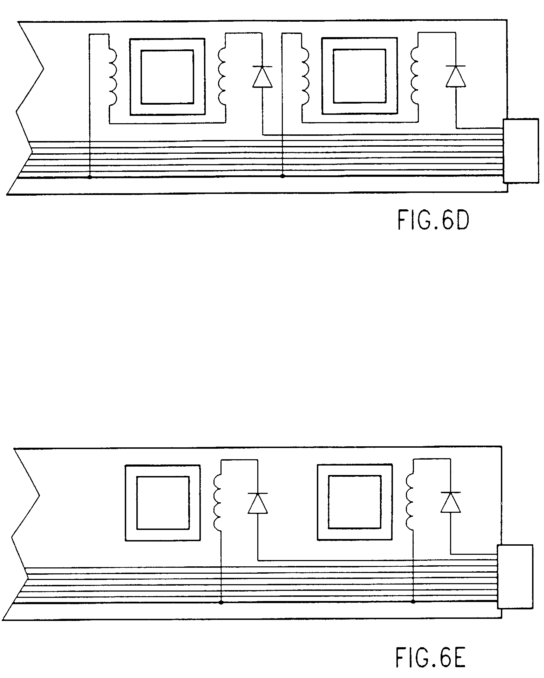

Reference is now made to Figs. 6A - 6E, which illustrate three alternative arrangements of couplers 75. The arrangement of Fig. 6A corresponds to that shown in Figs. 4 and 5. The arrangement of Fig. 6B corresponds to that shown in Fig. 3 with the addition of diodes 80. The arrangement of Fig. 6C corresponds to that shown in Fig. 3. Here the diodes 80 are incorporated in the driver card 54 or receiver card 42 (both shown in Fig. 2). Figs. 6D and 6E illustrate arrangements corresponding to those of Figs. 6A and 6B but with the opposite diode direction.

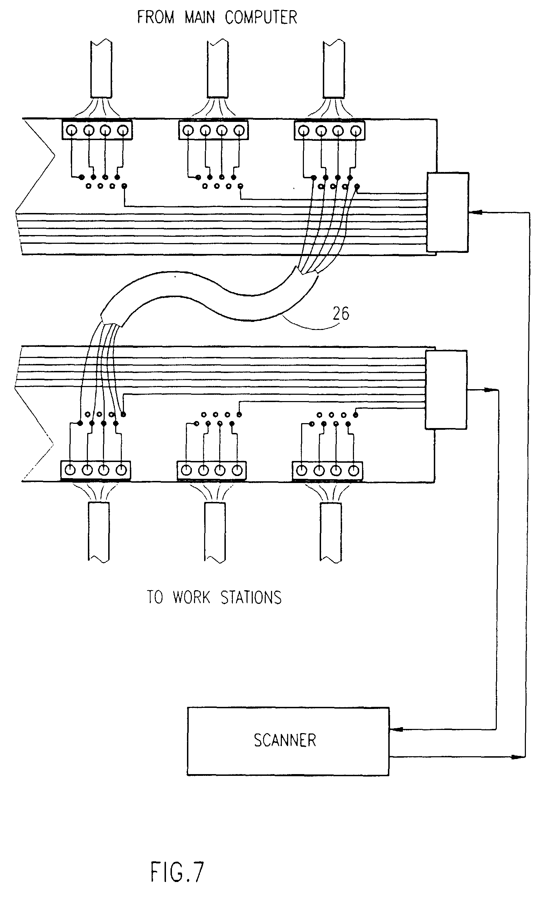

Reference is now made to Fig. 7, which illustrates an alternative embodiment of the invention of Figs. 1 and 2, wherein the inductive couplers 75 are replaced by dry contacts to a conductor coupled to either of the computer port 16 or the user port 20. In Fig. 7, an arrangement is shown wherein the dry contact between the driver card or the receiver card and the port is made to a conductor which is dedicated to this purpose and does not carry any other signal.

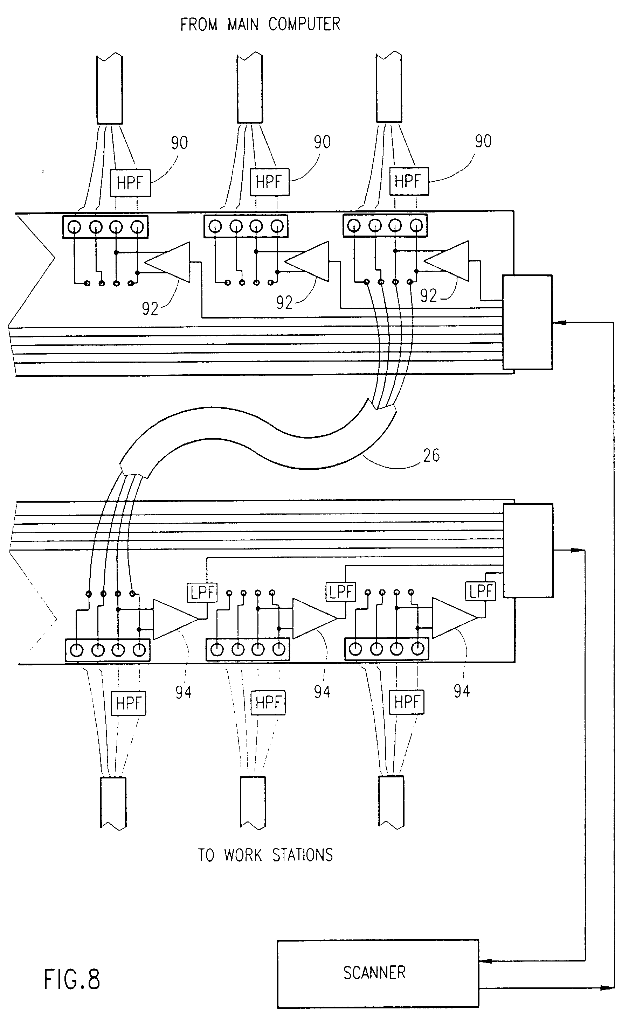

Fig. 8 illustrates a variation of the embodiment of Fig. 7, wherein a dry contact connection is made to conductors which also serves to carry other signals. In the embodiment of Fig. 8, a preferred common mode signal imposition technique is employed wherein differential drivers 92 are employed to impose low-frequency signals onto two conductors which also carry data. Differential amplifiers 94 are employed for receiving the imposed signals, preferably through low pass filters which can be seen associated with the signal pick-ups.

By virtue of the low pass filters, only common mode imposed signals are admitted to amplifiers 9. Computer or workstation data signals, preferably having relatively high frequencies, are filtered out by the low pass filters. As can be seen in Fig. 8, high pass filters 90 are interposed between the ports and the main computer or workstations. By virtue of the high pass filters, only data signal are received by the computer or workstations, while the lower frequency common mode signals are filtered out.

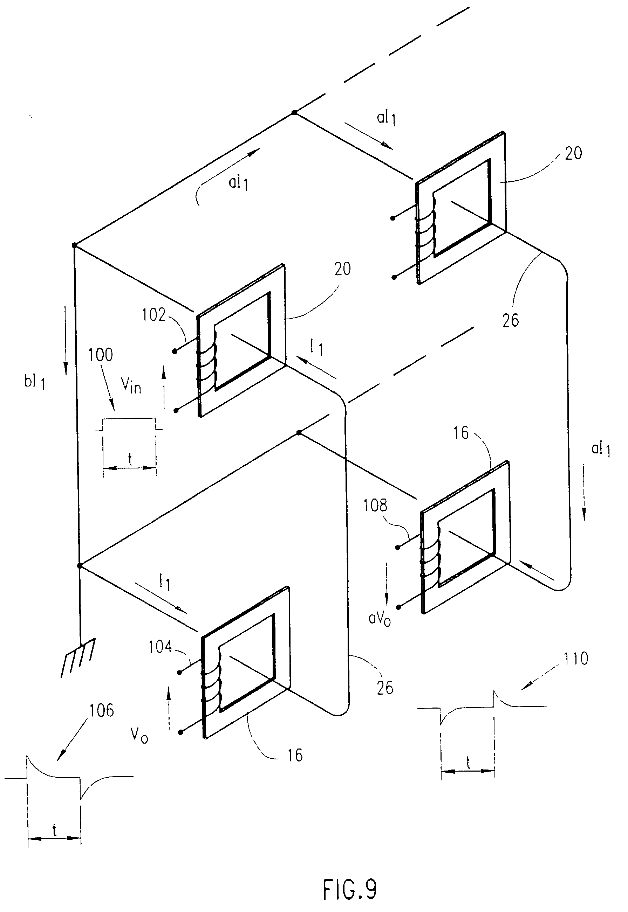

Reference is now made to Fig. 9, which is employed to illustrate particular features of the operation of the apparatus of the invention. The patch cable interconnection between ports 16 and 20 provides a signal path I1, such that if a square wave signal, Vᵢₙ, indicated by reference numeral 100 is transmitted via an induction coupling coil 102 along path I1, the time derivative of that signal as received at port 16 and picked up by an induction coupling coil 104 will appear as indicated at reference numeral 106.

Due to unwanted current flows within the distribution panel, there are also present additional, unwanted, signal paths, which are represented in Fig. 9 by a signal path aI1, where "a", represents an attenuation factor, less than unity. It has been appreciated by the inventors that the time derivative of the signal 100 which is received over the unwanted signal paths has an opposite polarity from that of the signal 106 received at the opposite end of the patch cable. Accordingly, the signal picked up by coils 108 lying along the unwanted signal path or paths aI1 and downstream of a patch cable 26 have a time derivative which appears as indicated by reference numeral 110.

It is a particular feature of the present invention that the polarity difference in the signal time derivative is employed to enable the scanner 30 to differentiate signals passed along a patch cable or its equivalent conductor from signals passed along unwanted signal paths.

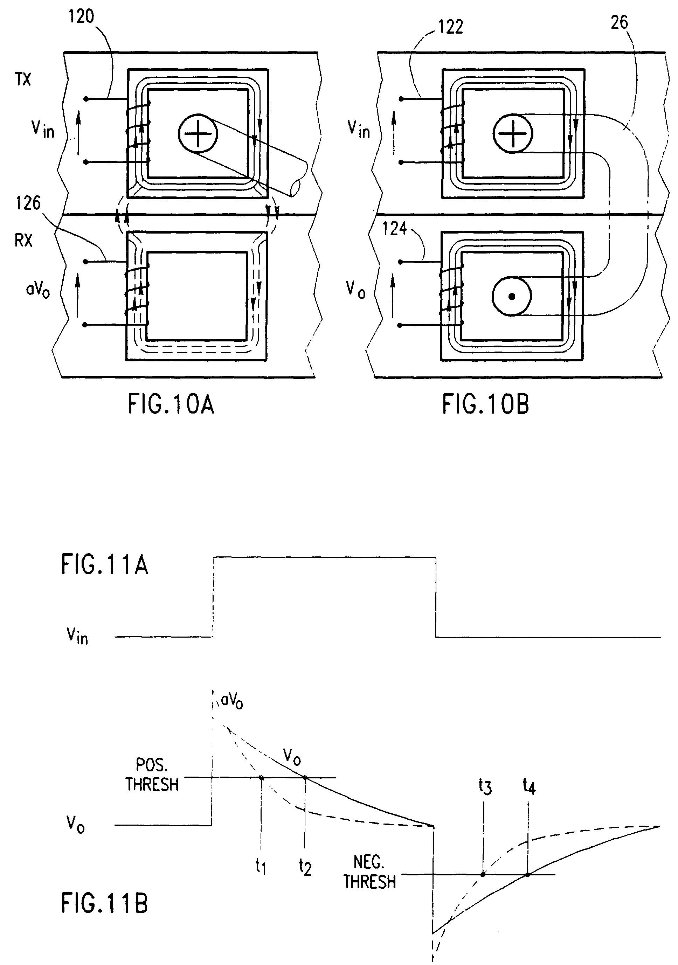

Reference is now made to Figs. 10A and 10B which illustrate another aspect of the operation of the apparatus of the invention. Where ports which receive signals from scanner 30 are physically adjacent ports at which signals are picked up, signal flux leakage can result in unwanted signal reception at ports which are not connected by a patch cable to a port receiving that signal.

Fig. 10A illustrates first and second adjacent ports which are not connected by a patch cable or equivalent but which are coupled in an unwanted manner by signal flux leakage. Fig. 10B illustrates similar adjacent ports which are connected by a cable such as patch cable 26 or its equivalent.

Assuming that in both cases a voltage signal of the type illustrated in Fig. 11A is applied to respective induction coils 120 and 122, the signal received at a coil 124 along the patch cable 26 or its equivalent will appear as indicated by solid line Vₒ and has a first decay time constant, while the signal received at a coil 126 due to signal flux leakage will appear as in in by line aVₒ and has a second decay time constant, which is shorter than the first decay time constant. This is true because the ratio of inductance to resistance, which determines the decay time constant, is much greater for the signal path including a patch cable than for a signal path not including a patch cable.

The relationship between the two signals Vₒ and aVₒ is illustrated in Fig. 11B, from where it can be seen that application of positive and/or negative thresholds can be employed to distinguish between the two signals. As can be seen in Fig. 11B, signal aVₒ reaches a preselected positive threshold at time t₁, following a positive peak, and a preselected negative threshold at time t₃, following a negative peak. Signal Vₒ, in contrast, reaches the positive threshold at time t₂, later than t₁, and the negative threshold at time t₄, later than t₃. The differences in times, between t₂ and t₁ and between t₃ and t₄, are useful for distinguishing between signals Vₒ and aVₒ. Circuitry which employs either or both of these thresholds is preferably incorporated into the apparatus of the present invention.

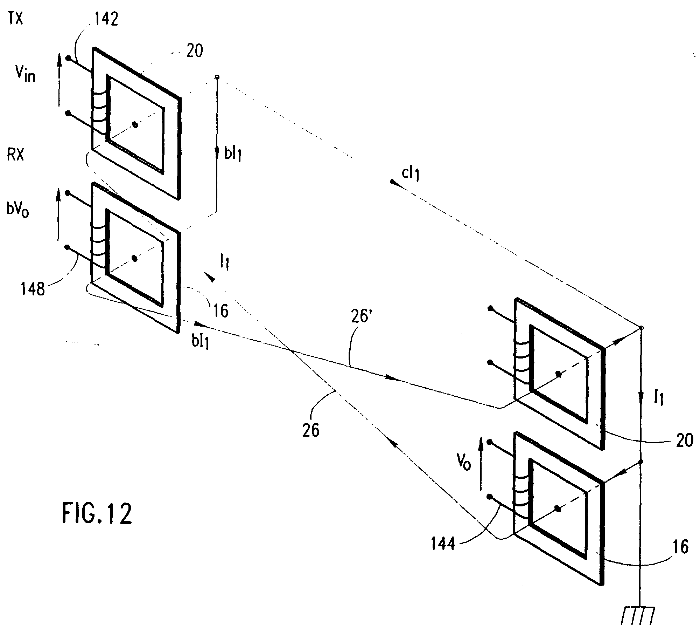

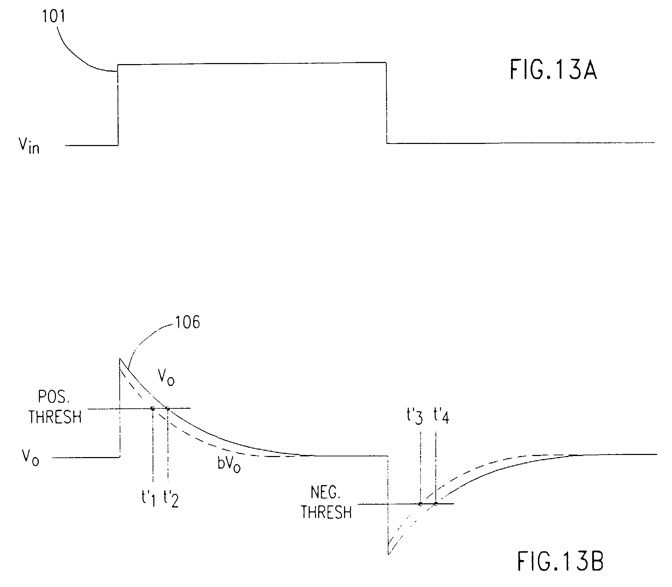

Reference is now made to Fig. 12, 13A and 13B, which are employed to illustrate additional particular features of the operation of the apparatus of the invention. The patch cable interconnection between ports 16 and 20 provides a signal path I1, such that if a square wave signal, Vᵢₙ, indicated by reference numeral 101 in Fig. 13A is transmitted via an induction coupling coil 142 along path I1, the time derivative of that signal as received at port 16 and picked up by an induction coupling coil 144 will appear as indicated at reference numeral 106 in Fig. 13B.

Due to unwanted current flows within the distribution panel, there are, also present additional, unwanted, signal paths, which are represented in Fig. 12 by a signal path bI1, where b, represents an attenuation factor, less than unity. It has been appreciated by the inventors that the time derivative of the signal 101 which is received over the unwanted signal paths has the same polarity as that of the signal 106 received at the opposite end of the patch cable.

Accordingly, the signal bVₒ picked up by coils 148 lying along the unwanted signal path or paths bI1 and downstream of another patch cable 26' is not distinguishable from signal 106 by its time derivative. Furthermore, in contrast to signal aVₒ of Fig. 10A, signal bVₒ is generally not distinguishable from signal 106 by its delay time constant. However, it has been appreciated by the present inventors that the signals picked up by coils 144 (the wanted signal) and 148 (the unwanted signal) in the arrangement of Fig. 12 may be distinguished by their relative amplitude.

It is a particular feature of an embodiment of the present invention that the amplitude of the signals is employed to enable the scanner 30 to differentiate signals passed along a patch cable or its equivalent conductor directly between connected ports from signals passed along the unwanted signal paths.

The relationship between the two signals Vₒ and bVₒ is illustrated in Fig. 13B from where it can be seen that application of positive and/or negative thresholds can be employed to distinguish between the two signals, as described above with reference to Fig. 11B. As can be seen in Fig. 13B, signal bVₒ reaches a preselected positive threshold at time t₁', following a positive peak, and a preselected negative threshold at time t₃', following a negative peak. Signal Vₒ reaches the positive threshold at time t₂', later than t₁', and the negative threshold at time t₄', later than t₃'. The time differences, namely, t₂' minus t₁' t₃' minus t₄', which result from the different amplitudes of signals V₀ and bV₀, are useful for distinguishing between signals V₀ and bV₀. Circuitry which employs these thresholds is incorporated into the apparatus of the present invention.

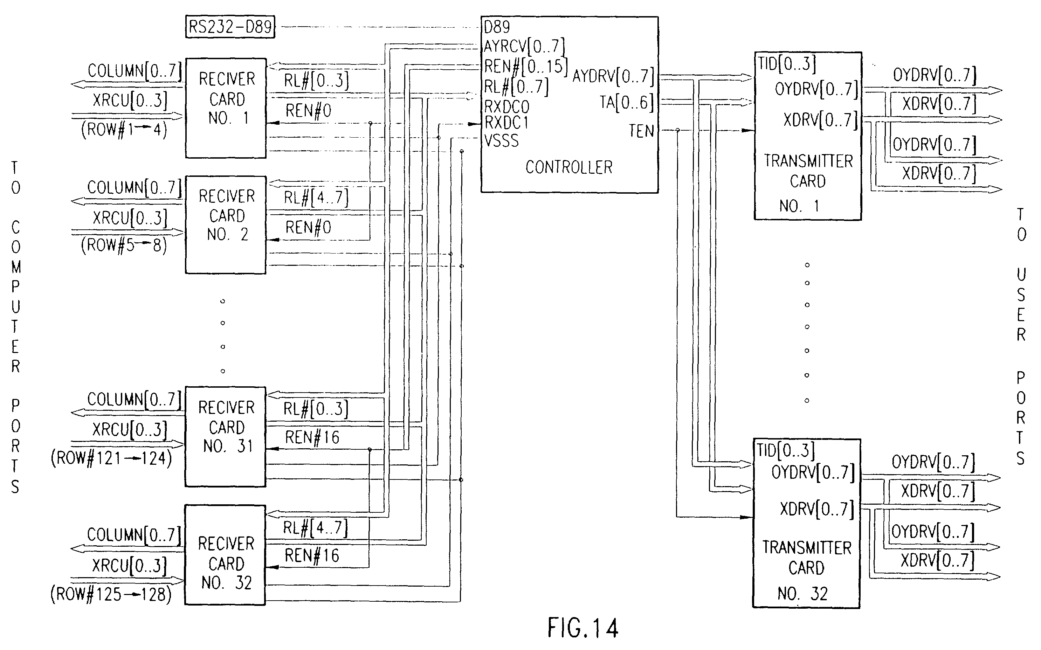

Reference is now made to Fig. 14, which is an overall schematic illustration of a preferred embodiment of the invention corresponding to Fig. 2.

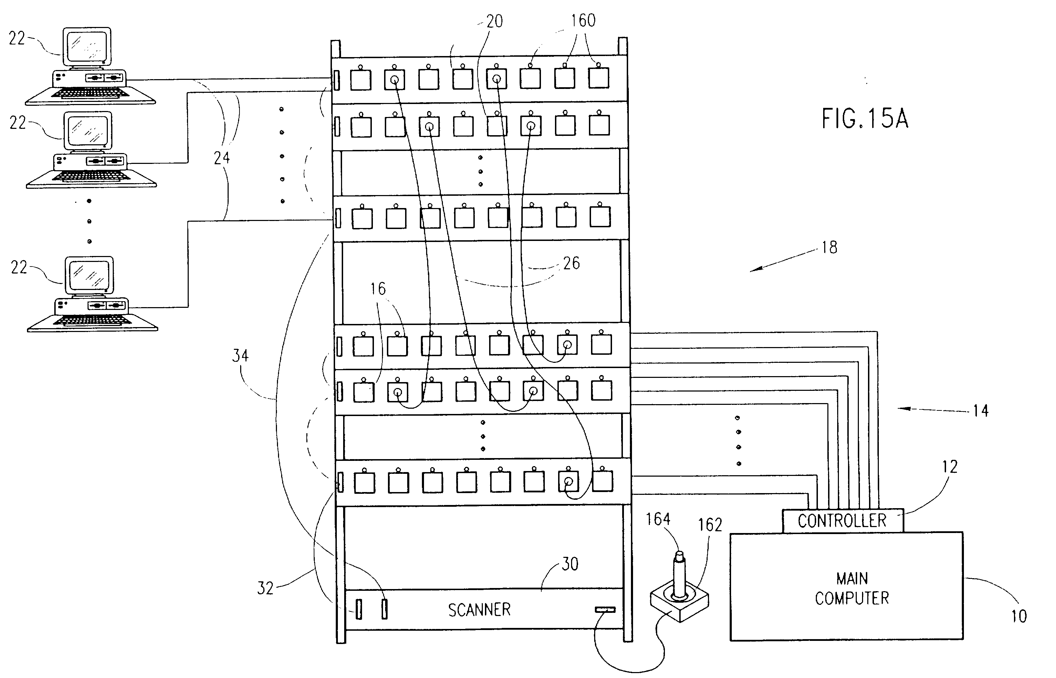

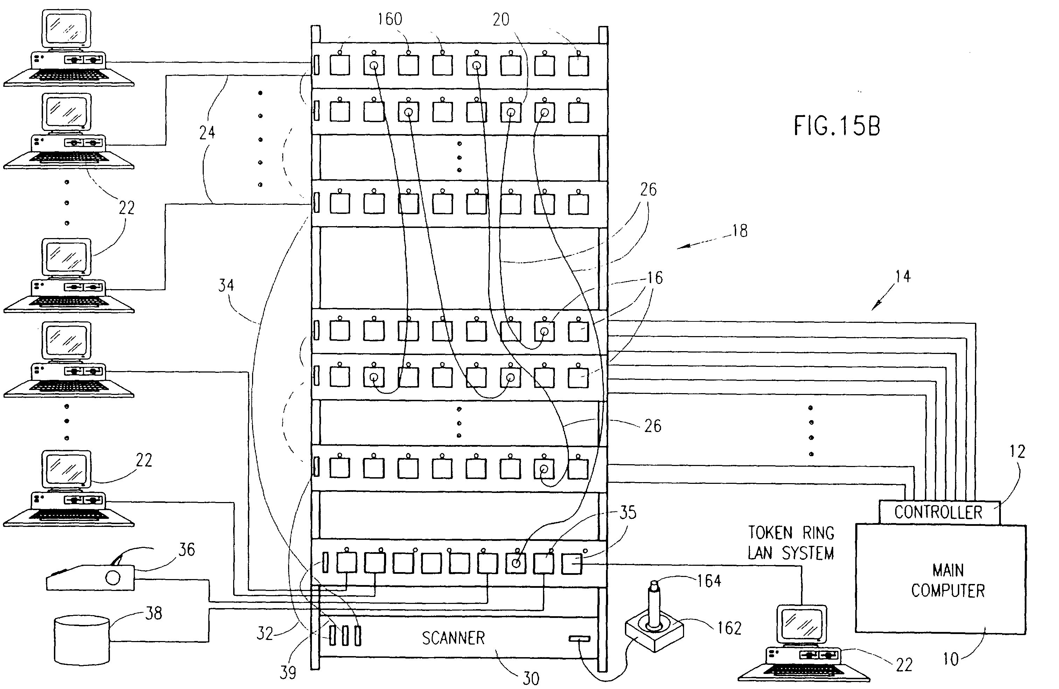

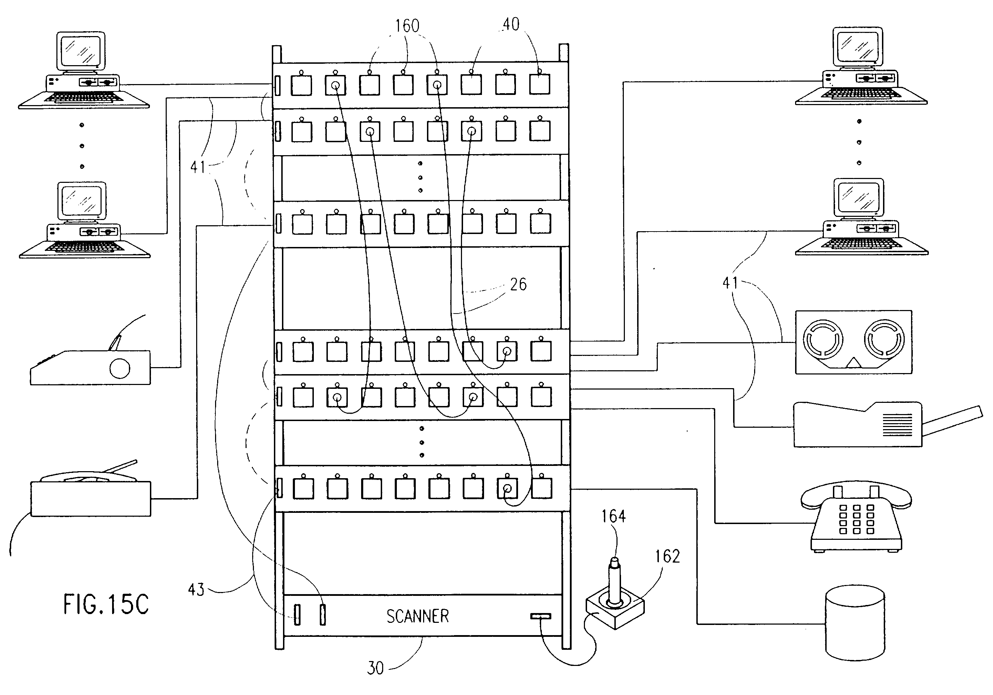

Reference is now made to Figs. 15A, 15B, 15C, 16 and 17 which illustrate an alternative embodiment of the apparatus of Figs. 1A - 1C, 4 and 7. The apparatus shown in Figs. 15A - 15C, 16 and 17 is similar or identical to that of corresponding Figs. 1A - 1C, 4 and 7 with the addition of a further feature, the provision of a visual indication of interconnection between interconnected data ports by means of light sources associated with the data ports.

As illustrated in Figs. 15A - 15C LEDs 160 are associated with each of the ports 16 and 20. The LEDs 160 are each electrically connected to the circuit which passes through each port. scanning of each of the ports 16 and 20 to illuminate the LED 160 corresponding to that port and the port connected thereto by patch cord 34 or otherwise may be controlled by a hand operated device 162, such as a joystick, a four directional switch or a mouse. A button 164 can be used to permit scanning to be temporarily stopped.

Additionally or alternatively, the ports 160 may be scanned automatically by scanner 30. In this case, in contrast to normal scanning operation of scanner 30 being that the duration during which the LEDs are illuminated to indicate each pair of interconnected ports 16 and 20 is extended beyond the usual dwell time of the scanner 30 on each port pair. This change is effected by a straightforward change in the software of the scanner 30.

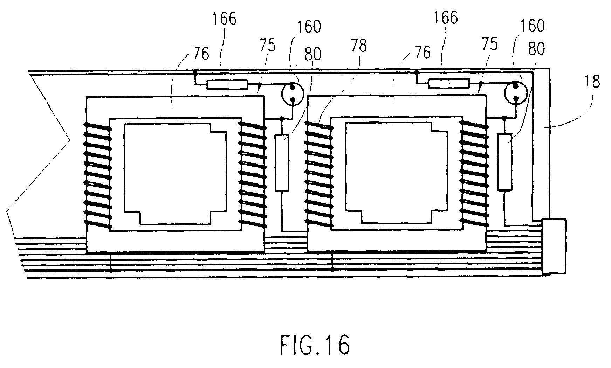

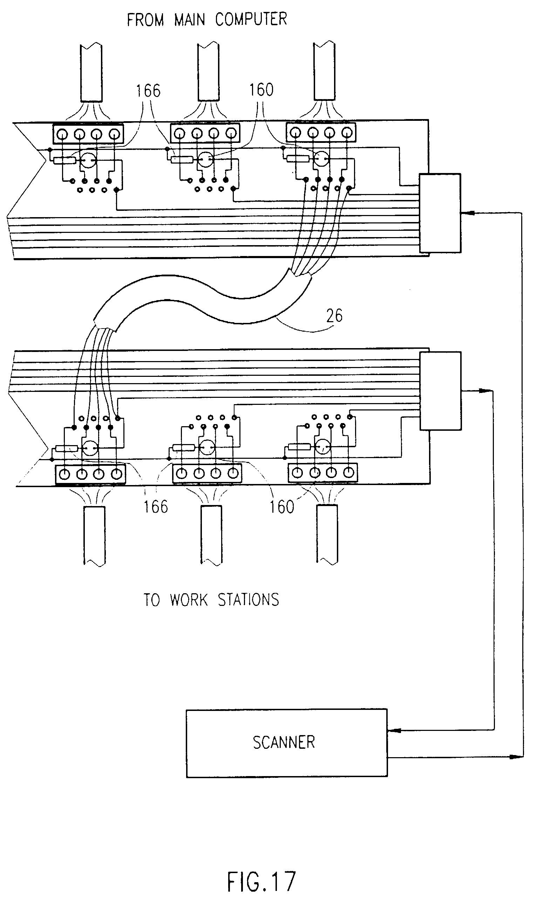

Figs. 16 and 17 illustrate a preferred connection of each LED 160 in series with a resistor 166 between coil 78 and resistor 80 and ground.

It will be appreciated by persons skilled in the art that the present invention is not limited by what has been particularly shown and described hereinabove. Rather the scope of the present invention is defined only by the claims.

## Claims

1. Apparatus for providing an indication of the connection pattern of a mulciplicicy of data ports (16,20), pluralities of which are interconnected by conductors (14,26), said apparatus comprising:
signal transducer means (48,54) operatively associated with at least some of said conductors at the ends thereof adjacent said data ports, at least one of said signal transducer means (54) associated with at least one of said conductors being operative to impose a signal on a portion of said conductor and at least one of said signal transducer means (48) associated with at least one of said conductors being operative to pick off said signal from said conductor;
a scanner (30) connected to said transducer means (54) for automatically scanning the interconnection arrangement of said conductors (14,26) and thus determining the interconnection status of said data ports (16,20), characterised in that
the apparatus also includes a plurality of visual indicators (80) each associated with one of said multiplicity of data ports, pairs of said visual indicators being simultaneously illuminated for providing an output indication of the interconnection status of pairs of data ports.

2. Apparatus according to claim 1 and also comprising means for distinguishing signals passing along predetermined signal paths from signals passing along other signal paths, according to their phase.

3. Apparatus according to claim 1 or claim 2 and also comprising means for distinguishing signals passing along predetermined signal paths from signals passing along other signal paths, according to their delay time constant.

4. Apparatus according to any of claims 1 - 3 and also comprising means for distinguishing signals passing along predetermined signal paths from signals passing along other signal paths, according to their amplitude.

5. Apparatus according to any of claims 1 - 4 wherein at least some of said conductors (14,26) are arranged in a plurality of cables, each cable including at least one of said conductors.

6. Apparatus according to claim 5 wherein the plurality of cables (14,26) comprise shielded cables and wherein said signal transducer means (48,54) comprises induction means (75) operatively associated with shielding of said shielded cables at the ends thereof adjacent said data ports (16, 20), at least one of said induction means associated with each shielded cable being operative to impose a signal on said shielding of said cable and at least one of said induction means associated with each shielded cable being operative to pick off said signal from said shielding of said cable.

7. Apparatus according to any of claims 1 - 6 wherein said signal transducer means (54) is operative to impose a signal on at least one conductor (14,26) which does not carry any other signal.

8. Apparatus according to any of claims 1 - 7 wherein said signal transducer means (54) is operative to impose a signal on at least one conductor (14,26) which may carry other signals and includes means for isolating said signal imposed thereby from said other signals, thereby to prevent unacceptable interference therewith.

9. Apparatus according to any of claims 1 - 8 wherein said indication of said connection pattern of said data ports (16,20) is provided automatically.

10. Apparatus according to claim 6, wherein said visual indicators (80) are LEDs electrically associated with said induction means (75).

11. Apparatus according to claim 1 and also comprising manually controllable means for scanning said ports (16,20) to provide indication of said pairs of interconnected ports by a light source apparatus.

12. A local area network comprising cabling (24, 41) interconnecting a plurality of workstations (22), said cabling comprising apparatus according to any one previous claim, wherein said conductors (14, 26) are used for selectable and removable interconnection between selected ones of said data ports.

13. A computer system comprising at least one main computer (10), a plurality of workstations (22) and a local area network interconnecting said at least one main computer and said plurality of workstations, said local area network comprising:
apparatus according to any of claims 1 - 11, wherein the multiplicity of data ports (40) includes at least one computer port (16) and a plurality of user ports (22) and wherein said conductors (14,26) are used for selectable and removable interconnection between selected ones of said user ports and said at least one computer port, thereby providing an indication of the connection pattern of said at least one computer port and said user ports.

14. An apparatus according to any of claims 1-11 or a local area network according to claim 12 or a computer system according to claim 13 wherein said scanner (30) includes means for extending the duration during which the light sources are illuminated beyond the usual dwell time of the scanner on each interconnected pair of data ports (16, 20).

## Patentansprüche

1. Vorrichtung zum Liefern einer Anzeige des Verbindungsmusters einer Mehrzahl von Datenports (16, 20), von denen Mehrzahlen durch Leiter (14, 26) verbunden sind, wobei die Vorrichtung aufweist:
eine Signalwandlereinrichtung (48, 54), die betriebsmäßig zumindest einigen der Leiter zugeordnet ist an den Enden davon neben den Datenports, wobei zumindest eine der Signalwandlereinrichtung (54), die zumindest einem der Leiter zugeordnet ist, derart betreibbar ist, daß sie ein Signal auf einen Abschnitt des Leiters überlagert und zumindest eine der Signalwandlereinrichtungen (48), welche zumindest einem der Leiter zugeordnet ist, derart betreibbar ist, daß sie das Signal von dem Leiter abgreift;
einen Scanner (30), der mit der Wandlereinrichtung (54) verbunden ist, zum automatischen Scannen der Verbindungsanordnung der Leiter (14, 26) und somit zum Bestimmen des Verbindungsstatus der Datenports (16, 20), dadurch gekennzeichnet, daß:
die Vorrichtung ebenfalls eine Vielzahl von visuellen Indikatoren (80) aufweist, welche jeweils einem der Vielzahl von Datenports zugeordnet sind, wobei Paare der visuellen Indikatoren simultan zum Erzeugen einer Ausgangsanzeige des Verbindungsstatus der Paare von Datenports erleuchtet sind.

2. Vorrichtung nach Anspruch 1, welche weiterhin eine Einrichtung zum Unterscheiden von Signalen, welche entlang vorbestimmter Signalwege laufen, von Signalen, die entlang anderer Signalwege laufen, gemäß ihrer Phase aufweist.

3. Vorrichtung nach Anspruch 1 oder Anspruch 2, welcher weiterhin eine Einrichtung zum Unterscheiden von Signalen, welche entlang vorbestimmter Signalwege laufen, von Signalen, welche entlang anderer Signalwege laufen, gemäß ihrer Verzögerungszeitkonstante aufweist.

4. Vorrichtung nach einem der Ansprüche 1 bis 3, welche weiterhin eine Einrichtung zum Unterscheiden von Signalen, welche entlang vorbestimmter Signalwege laufen, von Signalen, welche entlang anderer Signalwege laufen, gemäß ihrer Amplitude aufweist.

5. Vorrichtung nach einem der Ansprüche 1 bis 4, wobei zumindest einige der Leiter (14, 26) in einer Vielzahl von Kabeln angeordnet sind, wobei jedes Kabel zumindest einen der Leiter enthält.

6. Vorrichtung nach Anspruch 5, wobei die Vielzahl von Kabeln (14, 26) abgeschirmte Kabel aufweist, und wobei die Signalwandlereinrichtung (48, 54) eine Induktionseinrichtung (75) aufweist, die betriebsmäßig der Abschirmung der abgeschirmten Kabel an deren Enden neben den Datenports (16, 20) zugeordnet ist, wobei zumindest eine der Induktionseinrichtungen, die jedem abgeschirmten Kabel zugeordnet ist, derart betreibbar ist, daß sie der Abschirmung des Kabels ein Signal auferlegt, und wobei zumindest eine der Induktionseinrichtungen, die jedem abgeschirmten Kabel zugeordnet ist, derart betreibbar ist, daß sie das Signal von der Abschirmung des Kabels abgreift.

7. Vorrichtung nach einem der Ansprüche 1 bis 6, wobei die Signalwandlereinrichtung (54) derart betreibbar ist, daß sie ein Signal auf zumindest einen Leiter (14, 26) auferlegt, welcher nicht irgendein anderes Signal führt.

8. Vorrichtung nach einem der Ansprüche 1 bis 7, wobei die Signalwandlereinrichtung (54) derart betreibbar ist, daß sie ein Signal auf zumindest einen Leiter (14, 26) auferlegt, welcher andere Signale tragen kann, und welche eine Einrichtung zum Isolieren des dadurch auferlegten Signals von den anderen Signalen aufweist, so daß eine nicht akzeptable Interferenz dazwischen vermeidbar ist.

9. Vorrichtung nach einem der Ansprüche 1 bis 8, wobei die Anzeige des Verbindungsmuster der Datenports (16, 20) automatisch vorsehbar ist.

10. Vorrichtung nach Anspruch 6, wobei die visuellen Indikatoren (80) LEDs sind, welche elektrisch der Induktionseinrichtung (75) zugeordnet sind.

11. Vorrichtung nach Anspruch 1, welche ebenfalls eine manuell steuerbare Einrichtung zum Scannen der Ports (16, 20) zum Liefern der Anzeige der Paare von verbundenen Ports durch eine Lichtquellenvorrichtung aufweist.

12. Lokalbereichsnetzwerk mit einer Verkabelung (24, 41) zum Verbinden einer Vielzahl von Workstations (22), wobei die Verkabelung eine Vorrichtung gemäß einem der vorhergehenden Ansprüche aufweist, wobei die Leiter (14, 26) zur selektierbaren und entfernbaren Verbindung zwischen ausgewählten Datenports verwendbar sind.

13. Computersystem mit zumindest einem Hauptcomputer (10), einer Vielzahl von Workstations (22) und einem Lokalbereichsnetzwerk zum Verbinden des zumindest einem Hauptcomputers und der Vielzahl von workstations, wobei das Lokalbereichsnetzwerk aufweist:
eine Vorrichtung nach einem der Ansprüche 1 bis 11, wobei die Mehrzahl der Datenports (40) zumindest einen Computerport (16) und eine Vielzahl von Benutzerports (22) aufweist, und wobei die Leiter (14, 26) zur selektierbaren und entfernbaren Verbindung zwischen ausgewählten der Benutzerports und dem zumindest einem Computerport verwendbar sind, um so eine Anzeige des Verbindungsmusters des zumindest einen Computerports und Benutzerports zu liefern.

14. Vorrichtung gemäß einem der Ansprüche 1 bis 11 oder Lokalbereichsnetzwerk gemäß Anspruch 12 oder Computersystem gemäß Anspruch 13, wobei der Scanner (30) eine Einrichtung zum Erstrecken der Dauer, während der die Lichtquellen erleuchtet sind, über die gewöhnliche Ruhezeit des Scanners an jedem verbundenen Teil von Datenports (16, 20) aufweist.

## Revendications

1. Appareil pour produire une indication du motif de connexion d'une multiplicité de ports de données (16, 20) dont des pluralités sont interconnectées par des conducteurs (14, 26), ledit appareil comprenant:
des moyens de transducteur de signal (48, 54) associés en fonctionnement à au moins certains desdits conducteurs au niveau de leurs extrémités adjacentes auxdits ports de données, au moins l'un desdits moyens de transducteur de signal (54) associé à au moins l'un desdits conducteurs étant opérationnel pour imposer un signal sur une partie dudit conducteur et au moins l'un desdits moyens de transducteur de signal (48) associé à au moins l'un desdits conducteurs étant opérationnel pour extraire ledit signal depuis ledit conducteur;
un dispositif de balayage (30) connecté auxdits moyens de transducteur (54) pour balayer automatiquement l'agencement d'interconnexion desdits conducteurs (14, 26) et pour ainsi déterminer l'état d'interconnexion desdits ports de données (16, 20), caractérisé en ce que:
l'appareil inclut également une pluralité d'indicateurs visuels (80) dont chacun est associé à l'un de ladite multiplicité de ports de données, des paires desdits indicateurs visuels étant éclairées simultanément pour produire une indication de sortie de l'état d'interconnexion de paires de ports de données.

2. Appareil selon la revendication 1 et comprenant également des moyens pour distinguer des signaux passant le long de voies de signal prédéterminées par rapport à des signaux passant le long d'autres voies de signal, en fonction de leurs phases.

3. Appareil selon la revendication 1 ou 2 et comprenant également des moyens pour distinguer des signaux passant le long de voies de signal prédéterminées par rapport à des signaux passant le long d'autres voies de signal, en fonction de leurs constantes de temps de retard.

4. Appareil selon l'une quelconque des revendications 1 à 3 et comprenant également des moyens pour distinguer des signaux passant le long de voies de signal prédéterminées par rapport à des signaux passant le long d'autres voies de signal, en fonction de leurs amplitudes.

5. Appareil selon l'une quelconque des revendications 1 à 4, dans lequel au moins certains desdits conducteurs (14, 26) sont agencés dans une pluralité de câbles, chaque câble incluant au moins l'un desdits conducteurs.

6. Appareil selon la revendication 5, dans lequel les câbles de la pluralité de câbles (14, 26) comprennent des câbles blindés et dans lequel lesdits moyens de transducteur de signal (48, 54) comprennent des moyens d'induction (75) associés en fonctionnement à un blindage desdits câbles blindés au niveau de leurs extrémités adjacentes auxdits ports de données (16, 20), au moins l'un desdits moyens d'induction associé à chaque câble blindé étant opérationnel pour imposer un signal sur ledit blindage dudit câble et au moins l'un desdits moyens d'induction associé à chaque câble blindé étant opérationnel pour extraire ledit signal depuis ledit blindage dudit câble.

7. Appareil selon l'une quelconque des revendications 1 à 6, dans lequel lesdits moyens de transducteur de signal (54) sont opérationnels pour imposer un signal sur au moins un conducteur (14, 26) qui ne transporte aucun autre signal.

8. Appareil selon l'une quelconque des revendications 1 à 7, dans lequel lesdits moyens de transducteur de signal (54) sont opérationnels pour imposer un signal sur au moins un conducteur (14, 26) qui peut transporter d'autres signaux et qui inclut des moyens pour isoler ledit signal ainsi imposé vis-à-vis desdits autres signaux pour ainsi empêcher une interférence inacceptable entre eux.

9. Appareil selon l'une quelconque des revendications 1 à 8, dans lequel ladite indication dudit motif de connexion desdits ports de données (16, 20) est produite automatiquement.

10. Appareil selon la revendication 6, dans lequel lesdits indicateurs visuels (80) sont des diodes électroluminescentes ou DEL associées électriquement auxdits moyens d'induction (75).

11. Appareil selon la revendication 1 et comprenant également des moyens commandables manuellement pour balayer lesdits ports (16, 20) afin de produire une indication desdites paires de ports interconnectés au moyen d'un appareil de source de lumière.

12. Réseau local comprenant un câblage (24, 41) interconnectant une pluralité de stations de travail (22), ledit câblage comprenant un appareil selon l'une quelconque des revendications précédentes, dans lequel lesdits conducteurs (14, 26) sont utilisés pour une interconnexion sélectionnable et amovible entre certains sélectionnés desdits ports de données.

13. Système d'ordinateur comprenant au moins un ordinateur principal (10), une pluralité de stations de travail (22) et un réseau local interconnectant ledit au moins un ordinateur principal et ladite pluralité de stations de travail, ledit réseau local comprenant:
un appareil selon l'une quelconque des revendications 1 à 11, dans lequel la multiplicité de ports de données (40) inclut au moins un port d'ordinateur (16) et une pluralité de ports utilisateur (22) et dans lequel lesdits conducteurs (14, 26) sont utilisés pour une interconnexion sélectionnable et amovible entre certains sélectionnés desdits ports utilisateur et ledit au moins un port d'ordinateur pour ainsi produire une indication du motif de connexion dudit au moins un port d'ordinateur et desdits ports utilisateur.

14. Appareil selon l'une quelconque des revendications 1 à 11 ou réseau local selon la revendication 12 ou système d'ordinateur selon la revendication 13, dans lequel ledit dispositif de balayage (30) inclut des moyens pour étendre la durée pendant laquelle les sources de lumière sont éclairées au-delà du temps de résidence habituel du dispositif de balayage sur chaque paire interconnectée de ports de données (16, 20).
